(19) Europäisches Patentamt
European Patent Office
Office européen des brevets

(11) EP 1 811 533 A2

(12) **EUROPEAN PATENT APPLICATION**

(43) Date of publication:
**25.07.2007 Bulletin 2007/30**

(51) Int Cl.:
***H01G 9/20*** *(2006.01)*

(21) Application number: **06255929.9**

(22) Date of filing: **21.11.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **20.01.2006 KR 20060006316**

(71) Applicant: **SAMSUNG ELECTRONICS CO., LTD.**
**Suwon-si**
**Gyeonggi-do 442-742 (KR)**

(72) Inventors:
- **Kim, Jin Young**
  **Suwon-si**
  **Gyeonggi-do 442-081 (KR)**
- **Pak, Chan Ho**
  **Gangnam-gu**
  **Seoul 135-842 (KR)**
- **Joo, Sang Hoon**
  **Yongin-si**
  **Gyeonggi-do 449-712 (KR)**
- **Park, Sang Cheol**
  **Songpa-gu**
  **Seoul 138-769 (KR)**
- **Cho, Sung Hen**
  **Dongdaemun-gu**
  **Seoul 130-100 (KR)**
- **Song, Ki Yong**
  **Songpa-gu**
  **Seoul 137-786 (KR)**
- **Noh, Chang Ho**
  **Yeongtong-gu**
  **Suwon-si**
  **Gyeonggi-do 443736 (KR)**

(74) Representative: **Kyle, Diana et al**
**Elkington and Fife LLP,**
**Prospect House**
**8 Pembroke Road**
**Sevenoaks,**
**Kent TN13 1XR (GB)**

(54) **Counter electrode for photovoltaic cell using supported catalyst**

(57) A counter electrode for a photovoltaic cell and a photovoltaic cell including the same include a transparent substrate and a catalyst layer formed on the transparent substrate using a supported catalyst. The counter electrode of the present invention has an economical preparation cost and process, and also has an enlarged contact area with an electrolyte layer of the cell, leading to improved catalytic activity. Thus, in the case where the counter electrode is applied to the photovoltaic cell, excellent photoconversion efficiency is exhibited. In an exemplary embodiment, the photovoltaic cell is a dye-sensitized photovoltaic cell including such a counter electrode.

**FIG. 2**

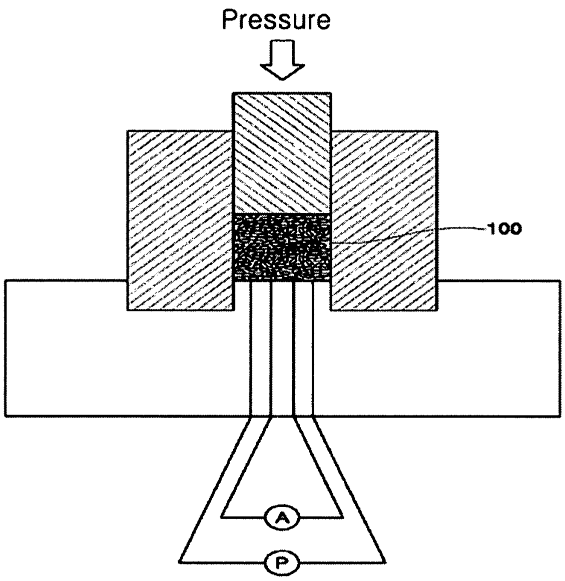


EP 1 811 533 A2

## Description

BACKGROUND OF THE INVENTION

1. Field of the Invention

The present invention relates, generally, to a counter electrode for a photovoltaic cell and a photovoltaic cell including the same, and more particularly, to a counter electrode for a photovoltaic cell, which can be prepared through simple and inexpensive processes using a supported catalyst composed of mesoporous carbon and metal catalyst particles supported therein, and to a photovoltaic cell including the same.

2. Description of the Related Art

In light of recent energy problems, thorough research into replacement energy sources for use instead of conventional fossil fuel has been conducted. In particular, in order to replace petroleum resources as an energy source, attempts have been made to use natural energy, such as wind power, atomic energy, solar energy, etc., because it is estimated that petroleum resources will be exhausted within decades.

Among these natural energy sources, a photovoltaic cell using solar energy may be unlimitedly employed and is environmentally friendly, unlike the other energy sources. Thus, the photovoltaic cell is highly spotlighted as a replacement energy source. In particular, a dye-sensitized photovoltaic cell has been researched and is of primary interest due to its very low fabrication cost.

Typically, the dye-sensitized photovoltaic cell has a structure including a semiconductor electrode which absorbs light to produce and transfer electrons; a counter electrode transferring electrons, which are returned after having been worked through external optional circuits, using a redox reaction at the solid/liquid interface with an electrolyte layer; and the electrolyte layer positioned between the semiconductor electrode and the counter electrode and acting as a path transferring ions to the semiconductor electrode.

In the photovoltaic cell, the counter electrode is composed of a conductive transparent substrate and a catalyst layer. Since the catalyst layer is used to promote the redox reaction, the activity thereof should be increased.

The catalyst layer is generally formed by sputtering or vacuum depositing metal particles having catalytic activity, such as platinum or palladium, on a transparent substrate. However, when such metal particles are used alone as the catalyst, a large amount of the catalyst is used, and expensive vacuum equipment for sputtering is required. Thus, the preparation thereof is not efficient or cost-effective. Further, the catalyst layer of the counter electrode has undesirable low catalytic activity due to the small reactive surface area of the electrolyte layer. Accordingly, the diameter of the catalyst particles should be decreased to the scale of ones of nm (e.g., 1 nm to 9 nm) in order to increase the reactive surface area and to decrease the usage amount of the catalyst particles.

In this regard, U.S. Patent Appl. Pub. No. 2005-0092359 discloses a photovoltaic cell provided with a counter electrode having a substrate and a conductive carbon layer. In this patent application, it is intended to increase the reactive surface area, to decrease the preparation cost and to realize an efficient preparation process, by forming the catalyst layer contained in the counter electrode using conductive carbon. However, the disclosure of this patent application suffers in that, because the counter electrode is formed using only carbon as a catalyst, it has a catalytic reactivity much lower than compared to catalysts formed of metal particles.

Thus, the development of a novel counter electrode capable of simultaneously achieving improved catalytic reactivity, preparation cost-effectiveness, and an efficient preparation process has become increasingly desired in recent years.

BRIEF SUMMARY OF THE INVENTION

Accordingly, the present invention has been made keeping in mind the above problems occurring in the related art, and an aspect of the present invention is to provide a counter electrode for a photovoltaic cell, which is economical in terms of preparation cost and preparation process and has high catalytic activity.

Another aspect of the present invention is to provide a dye-sensitized photovoltaic cell that includes the above counter electrode and thus exhibits excellent photoconversion efficiency.

In order to achieve the above aspects, the present invention provides a counter electrode for a photovoltaic cell including a transparent substrate and a catalyst layer formed on the transparent substrate using a supported catalyst.

As such, the supported catalyst may include mesoporous carbon and metal catalyst particles dispersed and supported in the mesoporous carbon.

In addition, the present invention provides a dye-sensitized photovoltaic cell comprising a semiconductor electrode, an electrolyte layer and a counter electrode.

BRIEF DESCRIPTION OF THE DRAWINGS

The above and other aspects, features and other advantages of the present invention will be more clearly understood from the following detailed description taken in conjunction with the accompanying drawings, in which:

FIG. 1 is a graph showing the result of BET surface area analysis of a mesoporous carbon prepared in Preparative Example 1 in accordance with the present invention;
FIG. 2 is a sectional side view showing a four point probe system for measuring sheet resistance of the mesoporous carbon prepared in Preparative Example 1 in accordance with the present invention;
FIG. 3 is a scanning electron micrograph (SEM) showing the surface of the mesoporous carbon prepared in Preparative Example 1 in accordance with the present invention;
FIG. 4 is a transmission electron micrograph (TEM) showing the surface of the supported catalyst prepared in Preparative Example 4 in accordance with the present invention; and
FIG. 5 is a graph showing a current-voltage curve of the photovoltaic cell fabricated in Example 2 in accordance with the present invention.

DETAILED DESCRIPTION OF THE INVENTION

The present invention will now be described more fully hereinafter with reference to the accompanying drawings, in which exemplary embodiments of the present invention are shown. The present invention may, however, be embodied in many different forms and should not be construed as limited to the exemplary embodiments set forth herein. Rather, these exemplary embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present invention.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

The present invention pertains to a counter electrode for a photovoltaic cell. The counter electrode includes a transparent substrate and a catalyst layer formed on the transparent substrate using a supported catalyst.

Conventionally, the counter electrode, which is formed by sputtering or vacuum depositing a metal catalyst itself on a transparent substrate, suffers because it has a high preparation cost and a complicated preparation process, and also yields a small reactive surface area, leading to low catalytic activity, as discussed above. However, since the counter electrode of the present invention is formed using a supported catalyst, the above problems can be eliminated

or effectively prevented. That is, in the present invention, a catalyst for the formation of the catalyst layer is a supported catalyst in which nano-sized metal catalyst particles are supported in mesoporous carbon. Hence, even with the use of a small amount of metal, a counter electrode having a large surface area can be easily prepared through a room-temperature solution process. Further, the loading amount of the metal catalyst particles can be freely controlled according to appropriate judgment by those skilled in the art, and thus, in particular, the preparation cost and the preparation process can be improved.

The supported catalyst used in the preparation of the counter electrode for the photovoltaic cell of the present invention is described below.

In the present invention, any supported catalyst, which is typically known for use as a supported catalyst, may be used. Preferably, a supported catalyst that includes mesoporous carbon and metal catalyst particles dispersed and supported in the mesoporous carbon may be used. As such, the metal catalyst particles are dispersed and distributed on the surface of the mesoporous carbon and in the pores thereof.

The mesoporous carbon, which is in the form of porous particles composed substantially of carbon, is a material having both micropores and mesopores in an appropriate ratio, unlike conventional amorphous microporous carbon powder having only micropores. According to the definition of The International Union of Pure and Applied Chemistry ("IUPAC"), the term 'micropore' means a pore having a diameter of about 2 nm or less, and the term 'mesopore' means a pore having a diameter of about 2 nm to about 50 nm.

The pores of the mesoporous carbon may be regularly arranged or not. In exemplary embodiments, the pores of the mesoporous carbon have a regular arrangement. Further, the micropores are interconnected through the mesopores, or the mesopores are interconnected through the micropores, regardless of the type of arrangement.

Such mesoporous carbon is characterized by an average mesopore size, a surface area, an average primary particle size and a sheet resistance.

In the present invention, any mesorporous carbon may be used without particular limitation so long as it is typically known in the art. Preferably, mesoporous carbon having an average mesopore size of about 2 nm to about 20 nm may be used. If the average mesopore size is less than 2 nm, the flow of electrons is poor and thus the activity of the catalyst is limited. On the other hand, if the average mesopore size exceeds 20 nm, the catalyst particles have a tendency to increase the size thereof upon preparation of the catalyst, undesirably decreasing the efficiency of the catalyst.

In addition, mesoporous carbon having a surface area of about 500 $m^2/g$ to about 2000 $m^2/g$ may be used. If the surface area is less than 500 $m^2/g$, it is difficult to increase the degree of dispersion of the metal particles to be supported because the surface area is too small. On the other hand, if the surface area is larger than 2000 $m^2/g$, excess micropores are present, and therefore the diffusion properties of electron or material are deteriorated, leading to decreased catalytic efficiency.

In addition, mesoporous carbon having an average primary particle size of about 100 nm to about 500 nm may be used. If the average primary particle size is less than 100 nm, the entire surface area is decreased due to high interparticular cohesion. On the other hand, if the average primary particle size exceeds 500 nm, the transfer of electrons and material becomes inefficient. In exemplary embodiments, the average primary particle size falls in the range of about 250 nm to about 500 nm.

In addition, mesoporous carbon having a sheet resistance of 350 $m\Omega/cm^2$ or less under a pressure of 75.4 $kg_f/cm^2$ may be used. Preferably, the mesoporous carbon has a sheet resistance of 250 $m\Omega/cm^2$ or less. If the mesoporous carbon has a sheet resistance exceeding 350 $m\Omega/cm^2$ under a pressure of 75.4 $kg_f/cm^2$, it undesirably functions to decrease the conductivity of the electrode and thus is limited in application to the counter electrode of a photovoltaic cell.

In the mesoporous carbon prepared using a carbon source, examples of the carbon source include, but are not limited to, carbohydrates, including monosaccharides, disaccharides, polysaccharides, and mixtures thereof; monomers, including furfuryl alcohol and aniline; gases, including acetylene and propylene; and phenanthrene. The mesoporous carbon may be used without limitation so long as it is prepared from a carbon-containing compound that may be polymerized (below, referred to as 'polymerizable carbon-containing compound') through various polymerization modes such as addition polymerization or polycondensation.

As such, examples of the monosaccharides include, but are not limited to, glucose, fructose, mannose, galactose, ribose and xylose, and examples of the disaccharides include, but are not limited to, sucrose, maltose and lactose. In exemplary embodiments, phenanthrene is most preferably used as the source of the mesoporous carbon. Phenanthrene is a compound having the structure of Formula 1 below, and cannot be replaced with anthracene, which is a structural isomer thereof.

Further, mesoporous carbon, prepared using phenanthrene as the carbon source, is drastically decreased in sheet resistance (sheet resistance of 250 mΩ/cm2 or less under a pressure of 75.4 $kg_f/cm^2$) by 30~80% compared to mesoporous carbons resulting from the use of the other carbon source, without sacrificing the other properties, and thus can exhibit more improvement in conductivity.

Formula 1

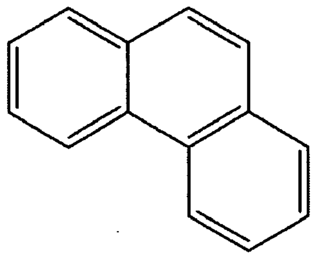

In addition, the mesoporous carbon may be prepared through a variety of processes for preparing mesoporous carbon known in the art. Specifically, for example, a carbon precursor mixture, which includes a polymerizable carbon-containing compound, a solvent, and a selectively usable acid, is prepared, after which mesoporous silica, serving as a template, is impregnated with the above mixture for a predetermined period of time. The resultant product is heat treated at a predetermined temperature (e.g., 50~250°C) and heat decomposed and thus carbonized (e.g., 400~1400°C), and silica is then removed therefrom using a silica soluble solution (e.g., an aqueous solution of hydrofluoric acid (HF) or an aqueous solution of sodium hydroxide (NaOH)), thus preparing a desired mesoporous carbon.

As such, the amount of each of the components of the precursor mixture is not particularly limited so long as it does not inhibit the purpose of the present invention. More specifically, for example, in the case where phenanthrene is used as the polymerizable carbon-containing compound, 5~15 wt% of phenanthrene, 10~35 wt% acid and 55~80 wt% of solvent may be used. In addition, the mesoporous silica template may be used without particular limitation so long as it is a molecular sieve material having a structure in which one-dimensional pores are interconnected through micropores. Preferably, examples of the mesoporous silica include MCM-48, SBA-1, SBA-15, KIT-1, MSU-1, etc.

Although the metal catalyst particles supported in the mesoporous carbon are not particularly limited, specific examples thereof include platinum (Pt), titanium (Ti), vanadium (V), chromium (Cr), manganese (Mn), iron (Fe), cobalt (Co), nickel (Ni), copper (Cu), zinc (Zn), aluminum (Al), molybdenum (Mo), selenium (Se), tin (Sn), ruthenium (Ru), palladium (Pd), tungsten (W), iridium (Ir), osmium (Os), rhodium (Rh), niobium (Nb), tantalum (Ta), lead (Pb), bismuth (Bi), or mixtures thereof.

The metal catalyst may be a single metal or an alloy of two or more metals. Since the metal catalyst is used in the catalyst layer of the counter electrode of the photovoltaic cell, the use of platinum or a platinum alloy is preferable.

When the average particle size of the metal catalyst particles is too small, there is a low probability of promoting the catalyst reaction. On the other hand, when the average particle size of the metal catalyst particles is too large a decreased reactive surface area of the catalyst particles results, thus lowering catalytic activity. Therefore, the average particle size of the metal catalyst particles is preferably in the range of about 1nm to about 5 nm.

As the process of preparing the supported catalyst of the present invention using the mesoporous carbon and the metal catalyst particles, a variety of supported catalyst preparation processes known in the art are used, such as impregnation, precipitation and a colloidal process. For example, the supported catalyst may be prepared by impregnating the mesoporous carbon with the metal catalyst precursor solution and then reducing the metal catalyst precursor. Such processes are specifically well known in the literature, and thus are not further described herein.

In the present invention, the amount of the metal catalyst particles in the supported catalyst may be freely controlled in the range of about 1~80 wt% depending on appropriate judgment by those skilled in the art. If the amount of the metal catalyst particles in the supported catalyst is too small, it is impossible to apply the catalyst to the photovoltaic cell. On the other hand, if the amount of metal catalyst particles in the supported catalyst is too large, economic benefits are negated, and the particle size of the catalyst may be increased. Thus, the metal catalyst particles are preferably used in an amount of about 40~80 wt% based on the total weight of the supported catalyst.

The counter electrode for a photovoltaic cell of the present invention includes the catalyst layer formed using the supported catalyst mentioned above. More, specifically, the counter electrode for a photovoltaic cell of the present invention includes a transparent substrate and the catalyst layer formed on the transparent substrate using the supported catalyst.

In the present invention, the catalyst layer is formed by uniformly dispersing the supported catalyst in an organic solvent to prepare a slurry or a paste, which is then applied on the transparent substrate through a general room-temperature solution process.

In this way, since the supported catalyst having the nano-sized metal catalyst particles supported therein is used, the counter electrode may be formed through a general room-temperature solution process, and thus, a high preparation cost is not required and the preparation process is not complicated.

As such, a typical organic solvent may be used as the organic solvent without limitation. Specific examples of the organic solvent include, for example, acetone, methanol, ethanol, isopropylalcohol, n-propylalcohol, butylalcohol, dimethylacetamide ("DMAc"), dimethylformamide, dimethylsulfoxide ("DMSO"), N-methyl-2-pyrrolidone ("NMP"), tetrahydrofuran ("THF"), tetrabutylacetate, n-butylacetate, m-cresol, toluene, ethyleneglycol ("EG"), ϒ-butyrolactone and hexafluoroisopropanol ("HFIP"), which may be used alone or in combination with any of the foregoing. Further, specific examples of the room-temperature solution process include, but are not limited to, spin coating, spray coating, screen printing, doctor blading and ink jetting, for example.

The transparent substrate is not particularly limited so long as it is transparent. Specifically, a glass substrate or a plastic substrate may be used. In order to increase the conductivity, the transparent substrate is preferably coated with conductive material, such as indium tin oxide ("ITO"), fluorine doped tin oxide ("FTO"), $ZnO-Ga_2O_3$, $ZnO-Al_2O_3$, $SnO_2-Sb_2O_3$, etc.

In addition, the present invention pertains to a dye-sensitized photovoltaic cell having the exemplary counter electrode.

Specifically, the photovoltaic cell of the present invention is composed of a semiconductor electrode, an electrolyte layer and the exemplary counter electrode mentioned above.

The counter electrode of the present invention has a low preparation cost and a simple preparation process. In addition, the surface area of the counter electrode in contact with the electrolyte layer is increased, leading to high catalytic activity. In the case where such a counter electrode is applied to the photovoltaic cell, electron transfer performance is improved, and therefore excellent photoconversion efficiency is realized.

In the photovoltaic cell, the semiconductor electrode has a structure that includes a transparent substrate, a semiconductor layer formed on the transparent substrate and a dye adsorbed on the surface of the semiconductor layer. The semiconductor electrode may be formed by applying porous metal oxide on the transparent substrate and sintering the metal oxide to form a metal oxide film, which is then impregnated with a dye solution for a predetermined period of time so as to adsorb the dye on the surface of the metal oxide film.

As such, a substrate that is the same as that used in the counter electrode of the present invention may be used as the transparent substrate. Although such a metal oxide is not particularly limited, at least one metal oxide selected from the group consisting of titanium oxide, niobium oxide, hafnium oxide, tungsten oxide, tin oxide and zinc oxide may be used.

The process of applying the metal oxide includes general coating processes, such as screen printing, spin coating, for example. The dye may be used without limitation so long as it is typically used in the field of photovoltaic cells. Specifically, examples of the dye include ruthenium complex; xanthene dyes, such as rhodamine B, rose bengal, eosin, or erythrosine; cyanine dyes, such as quinocyanine, or cryptocyanine; basic dyes, such as phenosafranine, capri blue, thiosine, or methylene blue; porphyrin compounds, such as chlorophyll, zinc porphyrin, or magnesium porphyrin; azo dyes; phthalocyanine compounds; complex compounds, such as Ru trisbipyridyl; anthraquinone dyes; and polycyclic quinone dyes, which may be used alone or in combination with any of the foregoing.

In addition, the electrolyte layer of the photovoltaic cell is formed of an electrolyte solution. For example, an acetonitrile solution of iodine, an NMP solution or 3-methoxypropionitrile may be used, but the present invention is not limited thereto. Any material may be used without limitation so long as it has a hole transport function.

Moreover, a method of fabricating the dye-sensitized photovoltaic cell having the above structure of the present invention is not particularly limited, and any method may be used without limitation so long as it is known in the art.

A better understanding of the present invention may be obtained in light of the following examples, which are set forth to illustrate, but are not to be construed to limit, the present invention.

[Preparation of Mesoporous carbon]

<Preparative Example 1>

0.9 g of phenanthrene and 2.7 g of para-toluene sulfuric acid were completely dissolved in 7.5 g of acetone to prepare a uniform precursor mixture. The precursor mixture was divided into proportions of 41. 0 (i) : 29.5 (ii) . 23.0(iii) : 6.5(iv), after which 1 g of SBA-15 was impregnated with the solution (i). The SBA-15 thus impregnated was dried for 30 minutes in a hood at room temperature and then further dried at 160°C for 10 minutes.

The dried product was further impregnated with the solution (ii), and then dried as mentioned above. Subsequently, the above impregnation and drying procedures were repeatedly conducted using the solutions (iii) and (iv), in that order.

The dried sample was cooled to room temperature, slowly heated to 200°C for 1 hour in a nitrogen atmosphere, and then allowed to stand for 6 hours. Thereafter, the sample was slowly heated to 900°C for 4 hours and then allowed to stand for 2 hours. A series of processes of adding the product thus carbonized to a mixture solution comprising HF, water and ethanol, and then stirring it, was repeated to remove the SBA-15, thereby preparing mesoporous carbon.

From the result of BET surface area analysis shown in FIG. 1, the mesoporous carbon thus prepared could be confirmed to have a surface area of 924 $m^2/g$ and a pore diameter of 5 nm. BET stands for Brunauer, Emmett, and Teller, the three scientists who optimized the theory for measuring surface area. The sheet resistance measured using a four point probe system was found to be 56.7 $m\Omega/cm^2$ under a pressure of 75.4 $kg_f/cm^2$ and 22.3 $m\Omega/cm^2$ under a pressure of 150.7 $kg_f/cm^2$. The sheet resistance was measured in a manner such that 50 mg of the mesoporous carbon 100 was introduced into the four point probe system shown in FIG. 2, and then respective pressures of the above two values were applied. The four point probe system had one pair of electrodes for measuring voltage and one pair of electrodes for measuring current (totaling 4 electrodes) provided on the bottom of a chamber receiving the measuring material. The scanning electron micrograph ("SEM") of the mesoporous carbon 100 is shown in FIG. 3.

<Preparative Example 2>

The mesoporous carbon was prepared in the same manner as in Preparative Example 1, with the exception that 1.5 g of sucrose was used instead of phenanthrene, and 0.18 g of sulfuric acid was used as the acid.

<Preparative Example 3>

The mesoporous carbon was prepared in the same manner as in Preparative Example 1, with the exception that the temperature was increased not to 900°C but to 1100°C upon carbonization.

[Preparation of Supported Catalyst]

<Preparative Example 4>

0.5 g of the mesoporous carbon prepared in Preparative Example 1 was introduced into a vinyl bag, after which 0.9616 g of $H_2PtCl_6$ was dissolved in 1.5 ml of acetone. This solution was introduced into the vinyl bag having the mesoporous carbon and then mixed. The mixture solution was dried in air for 4 hours, transferred into a crucible, and then dried in an oven at 60°c for about 12 hours. Subsequently, the crucible was loaded into an electric furnace in which nitrogen flows, and then nitrogen was supplied for 10 minutes, after which the flowing gas was converted into hydrogen. While the temperature was increased from room temperature to 200°C and then maintained for 2 hours, the platinum salt supported in the mesoporous carbon was reduced. After the gas was converted again into nitrogen, the temperature was increased to 350°C at a rate of 5°C/min, maintained for 5 hours, and then slowly decreased to room temperature. Subsequently, the carbon material was further impregnated with the solution of 0.9616 g of $H_2PtCl_6$ dissolved in 1.5 ml of acetone, followed by conducting a reduction process, thus obtaining a supported catalyst having 60 wt% platinum supported therein. The transmission electron micrograph ("TEM") of the supported catalyst thus obtained is shown in FIG. 4.

<Preparative Example 5>

The supported catalyst was prepared in the same manner as in Preparative Example 4, with the exception that the mesoporous carbon obtained in Preparative Example 2 was used.

<Preparative Example 6>

The supported catalyst was prepared in the same manner as in Preparative Example 4, with the exception that the mesoporous carbon obtained in Preparative Example 3 was used.

[Preparation of Counter Electrode]

<Example 1>

The supported catalyst prepared in Preparative Example 4 was dispersed in a dispersion of Nafion™ 115 (DuPont Corp.) in isopropylalcohol to prepare a slurry, which was then applied on a glass substrate coated with fluorine doped tin oxide ("FTO") through a spray process and thereafter burned at 400°C for 30 minutes, thus preparing the counter electrode of the present invention. As such, the applied catalyst had a concentration of 3 $mg/cm^2$ based on the amount of platinum.

[Fabrication of Photovoltaic Cell]

<Example 2>

A glass substrate was coated with fluorine doped tin oxide ("FTO") by sputtering, further coated with a paste of $TiO_2$ particles having a particle size of 13 nm by screen printing, and then burned at 450°C for 30 minutes, thus forming a porous $TiO_2$ film having a thickness of about 15 μm. Subsequently, the glass substrate having the $TiO_2$ film formed thereon was dipped into a solution of 0.3 mM ruthenium dithiocyanate 2,2'-bipyridyl-4,4'-dicarboxylate for 24 hours and then dried to adsorb the dye on the surface of $TiO_2$ layer, thus fabricating a semiconductor electrode.

Thereafter, the semiconductor electrode as a cathode was assembled with the counter electrode obtained in Example 1 as an anode. When both electrodes were assembled, the conductive surfaces of the anode and cathode were disposed facing into the cell so that the platinum layer and the light absorbing layer faced each other. As such, a polymer layer about 40 μm thick of SURLYN™ (DuPont Corp.) was interposed between the anode and cathode, and then the two electrodes were compressed at about 1~3 atm on a heating plate at about 100~140°C. Thereby, the polymer was attached to the surfaces of the two electrodes by heat and pressure.

Subsequently, the space between the two electrodes was filled with the electrolyte solution through fine holes formed in the surface of the anode, thus completing the dye-sensitized photovoltaic cell of the present invention. As the electrolyte solution, an $I^{3-}/I^-$ electrolyte solution comprising 0.6 M 1,2-dimethyl-3-octyl-imidazolium iodide, 0.2 M LiI, 0.04 M $I_2$ and 0.2 M 4-tert-butyl-pyridine ("TBP") dissolved in acetonitrile was used.

[Evaluation of Properties of Photovoltaic Cell]

In order to evaluate the photoconversion efficiency of the cell fabricated in Example 2, photovoltage and photocurrent were measured. As a light source, a Xenon lamp (Oriel, 01193) was used, and the radiation conditions (AM 1.5) of the Xenon lamp were corrected using a standard photovoltaic cell (Furnhofer Institute Solare Engeriessysteme, Certificate No. C-ISE369, Type of material: Mono-Si+ KG filter). The measured photocurrent-photovoltage curve is shown in FIG. 5. The short-circuit photocurrent density ($I_{sc}$), open-circuit voltage ($V_{oc}$) and fill factor (FF) calculated from the above curve were substituted into the following equation for calculating the photoconversion efficiency ($\eta_e$). The results are given in Table 1 below.

$$\eta_e = (V_{oc} \cdot I_{sc} \cdot FF) / (P_{inc})$$

wherein $P_{inc}$ shows 100 mW/$cm^2$ (1sun).

TABLE 1

| $I_{sc}$ (mA/$cm^2$) | Voc (mV) | FF (%) | Photoconversion Efficiency (%) |
|---|---|---|---|
| 4.064 | 684 | 63 | 1.757 |

As described hereinbefore, the present invention provides a counter electrode for a photovoltaic cell using a supported catalyst. In the present invention, the supported catalyst, comprising mesoporous carbon and metal catalyst particles supported therein, is used, and thus, the counter electrode may have an economical preparation cost and less complicated preparation process. As well, the area of the counter electrode in contact with an electrolyte layer is enlarged, leading to high catalytic activity. Further, there is provided a dye-sensitized photovoltaic cell having such a counter electrode, thereby exhibiting excellent photoconversion efficiency.

## Claims

1. A counter electrode for a photovoltaic cell, comprising:

   a transparent substrate; and
   a catalyst layer formed on the transparent substrate using a supported catalyst.

2. The counter electrode as claimed in claim 1, wherein the supported catalyst comprises mesoporous carbon; and

metal catalyst particles dispersed and supported in the mesoporous carbon.

**3.** The counter electrode as claimed in claim 2, wherein the mesoporous carbon has an average mesopore size of 2 nm to 20 nm.

**4.** The counter electrode as claimed in claim 2 or 3, wherein the mesoporous carbon has a surface area of 500 $m^2/g$ to 2000 $m^2/g$.

**5.** The counter electrode as claimed in any of claims 2 to 4, wherein the mesoporous carbon has an average primary particle size of 100 nm to 500 nm.

**6.** The counter electrode as claimed in any of claims 2 to 5, wherein the mesoporous carbon has a surface resistance of about 350 $m\Omega/cm^2$ or less under a pressure of 75.4 $kg_f/cm^2$.

**7.** The counter electrode as claimed in any of claims 2 to 6, wherein the mesoporous carbon is prepared using a carbon source selected from carbohydrates including monosaccharides, disaccharides, polysaccharides, and mixtures thereof; monomers including furfuryl alcohol and aniline; gases including acetylene and propylene; and phenanthrene.

**8.** The counter electrode as claimed in claim 7, wherein the carbon source is phenanthrene.

**9.** The counter electrode as claimed in any of claims 2 to 8, wherein the metal catalyst particles are selected from platinum (Pt), titanium (Ti), vanadium (V), chromium (Cr), manganese (Mn), iron (Fe), cobalt (Co), nickel (Ni), copper (Cu), zinc (Zn), aluminum (A1), molybdenum (Mo), selenium (Se), tin (Sn), ruthenium (Ru), palladium (Pd), tungsten (W), iridium (Ir), osmium (Os), rhodium (Rh), niobium (Nb), tantalum (Ta), lead (Pb), bismuth (Bi), and mixtures thereof.

**10.** The counter electrode as claimed in claim 9, wherein the metal catalyst particles are platinum (Pt).

**11.** The counter electrode as claimed in any of claims 2 to 10, wherein the metal catalyst particles have an average particle size of 1 nm to 5 nm.

**12.** The counter electrode as claimed in any of claims 2 to 11, wherein the metal catalyst particles are supported in the supported catalyst in an amount of 40~80 wt% based on a total weight of the supported catalyst.

**13.** The counter electrode as claimed in any of claims 1 to 12, wherein the catalyst layer is formed using a coating process selected from spin coating, spray coating, screen printing, doctor blading and ink jetting.

**14.** The counter electrode as claimed in any of claims 1 to 13, wherein the transparent substrate is coated with conductive material.

**15.** The counter electrode as claimed in any of claims 1 to 14, wherein the transparent substrate is a glass substrate or a plastic substrate.

**16.** A dye-sensitized photovoltaic cell, comprising:

a semiconductor electrode;
an electrolyte layer; and
a counter electrode for a photovoltaic cell, as claimed in any of claims 1 to 15.

# FIG. 1

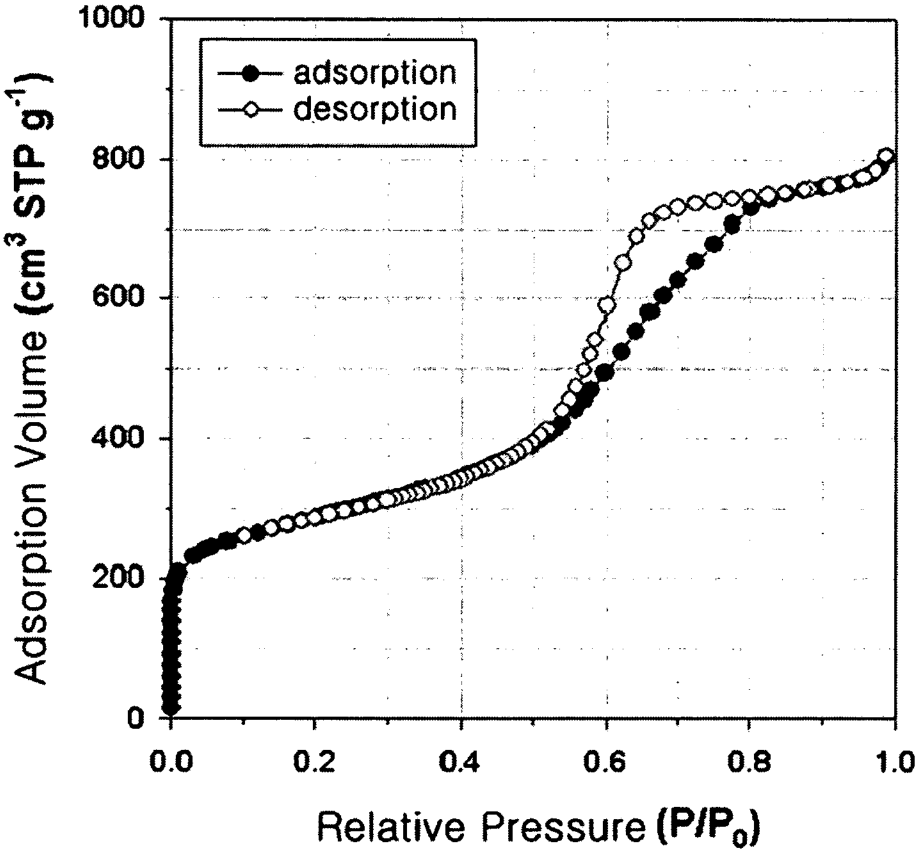
1000
800
600
400
200
0
0.0
0.2
0.4
0.6
0.8
1.0
adsorption
desorption
Adsorption Volume (cm3 STP g-1)
Relative Pressure (P/P0)

# FIG. 2

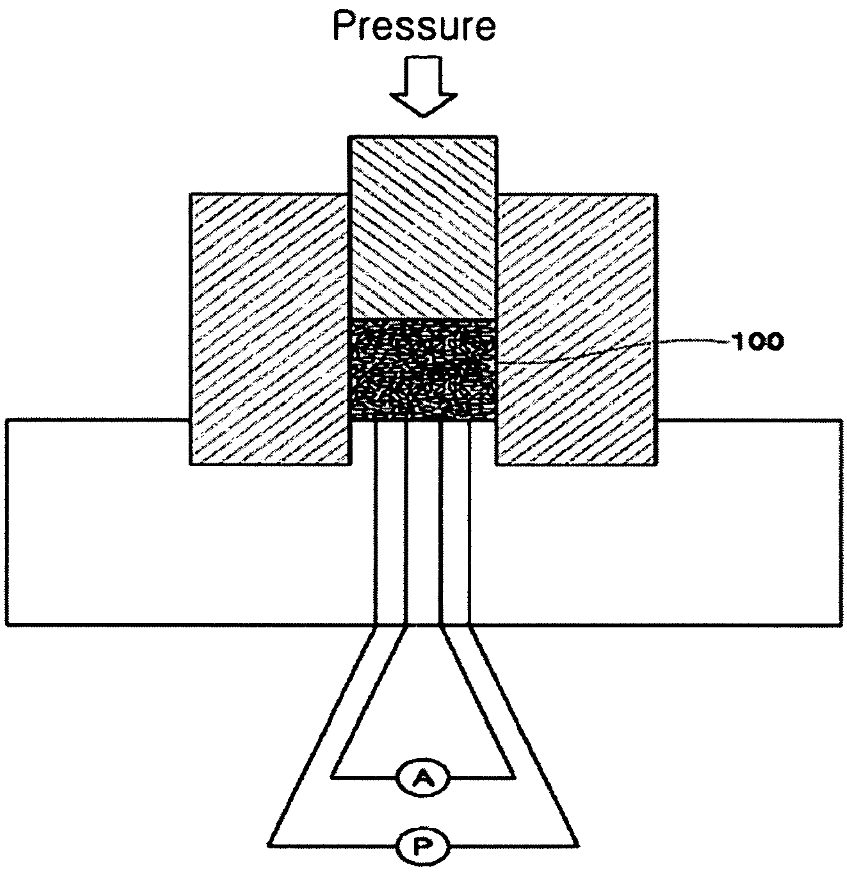

# FIG. 3

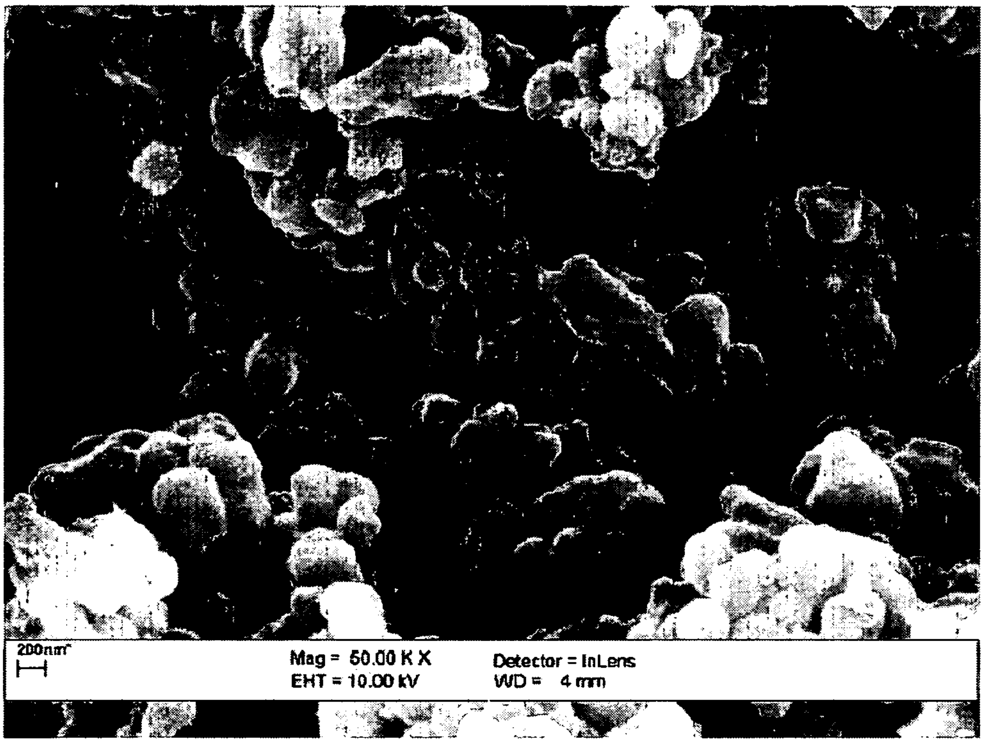

# FIG. 4

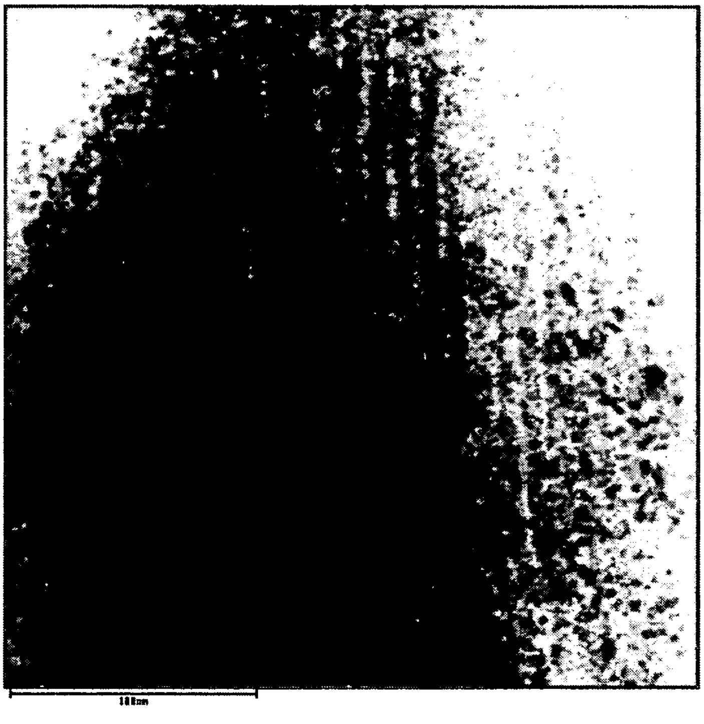

# FIG. 5

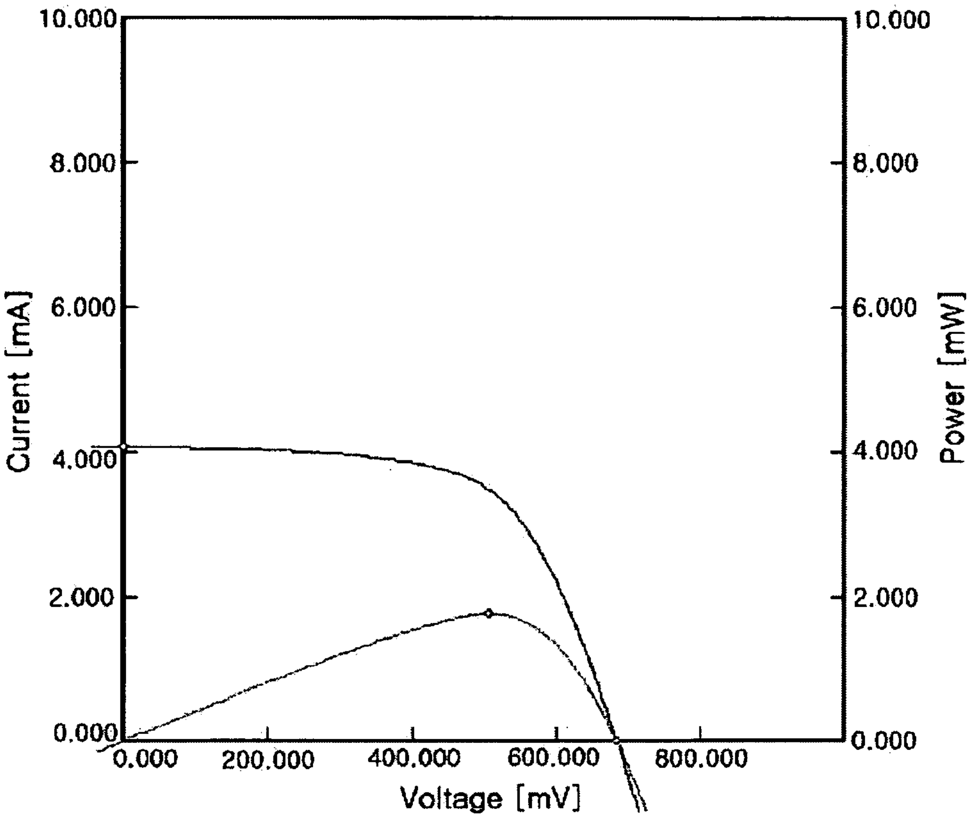
10.000
8.000
6.000
4.000
2.000
0.000
Current [mA]
10.000
8.000
6.000
4.000
2.000
0.000
Power [mW]
0.000
200.000
400.000
600.000
800.000
Voltage [mV]

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20050092359 A